# EUROPEAN PATENT APPLICATION

(11) **EP 4 421 852 A1**
(43) Date of publication of application: **28.08.2024**
(21) Application number: 21964472.1
(22) Date of filing: 22.11.2021
(51) Int. Cl.: H01L 21/56

(54) **PHOTOELECTRIC TRANSCEIVER ASSEMBLY AND METHOD FOR MANUFACTURING SAME**

(71) Applicant: Huawei Technologies Co., Ltd., Shenzhen, Guangdong 518129 (CN)
(72) Inventor: ZHANG, Wenqi, Shenzhen, Guangdong 518129 (CN); WANG, Meng, Shenzhen, Guangdong 518129 (CN)
(74) Representative: Goddar, Heinz J.
(86) International application number: PCT/CN2021/132160
(87) International publication number: WO 2023/087323

(57) **Abstract**

Embodiments of the present disclosure relate to a photoelectric transceiver assembly and a manufacturing method thereof. The photoelectric transceiver assembly includes: an electronic integrated circuit, including a first surface, a second surface opposite to the first surface, and a first sidewall located between the first surface and the second surface; a molding compound, plastically packaging the electronic integrated circuit around the first sidewall, where the molding compound includes a third surface close to the first surface and a fourth surface close to the second surface, and the molding compound is provided with one or more through mold vias extending from the third surface to the fourth surface; a first redistribution layer, disposed on the first surface and the third surface and including a plurality of first bumps electrically coupled to the first surface and the one or more through mold vias; a second redistribution layer, disposed on the second surface and the fourth surface and including a plurality of second bumps electrically coupled to the second surface and the one or more through mold vias; and a photonic integrated circuit, electrically coupled to the plurality of second bumps by using a plurality of first solder balls.

## Description

### TECHNICAL FIELD

Embodiments of the present disclosure generally relate to the field of electronic devices, and more specifically, to a photoelectric transceiver assembly and a manufacturing method thereof.

### BACKGROUND

Continuous growth of global data communication services promotes continuous development of silicon-based optoelectronics, especially wide application and development of a high-speed and high-bandwidth optical transceiver module based on silicon-based optoelectronics (also referred to as an optical engine). The optical transceiver module needs to integrate both a photonic chip (also referred to as a photonic integrated circuit, PIC for short) and an electronic chip (also referred to as an electronic integrated circuit, EIC for short), and further needs to implement coupling between a fiber array unit (FAU) and a waveguide array on the photonic chip. Currently, this integration mode faces two major technical challenges in high-density and highfrequency fields.
(1) It is very difficult to meet requirements for an input/output (I/O) density and an interconnection length in a conventional wire seating interconnection solution. To reduce a loss caused by a parasitic inductance and the like, it is required that an interconnection length between a driver on the electronic chip and a modulator on the photonic chip be minimized.
(2) To reduce a loss caused by coupling between the fiber array unit and the waveguide array, a specific region on a surface of the photonic chip and a sidewall that is used in side coupling to a waveguide array unit need to be protected in a packaging process, to prevent an optical port on the sidewall from being polluted before being connected to an optical fiber.

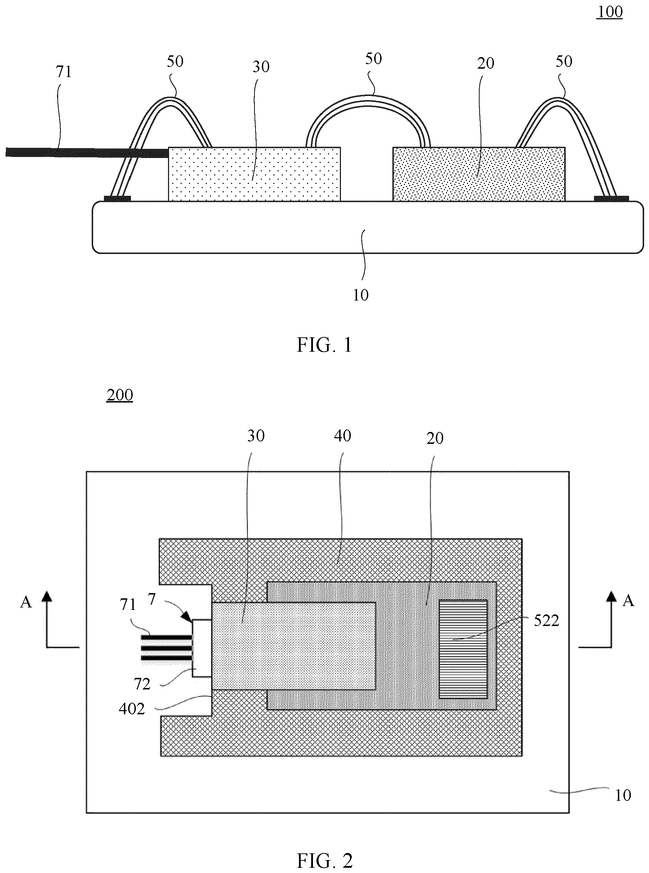

FIG. 1 is a schematic diagram of a structure of a conventional optical transceiver module 100. As shown in FIG. 1, the optical transceiver module 100 includes a substrate 10, an electronic integrated circuit 20, a photonic integrated circuit 30, and an optical fiber 71. The electronic integrated circuit 20 and the photonic integrated circuit 30 are arranged on the substrate 10, and are spaced. The electronic integrated circuit 20 is electrically coupled to the photonic integrated circuit 30 by using a bonding wire 50. Each of the electronic integrated circuit 20 and the photonic integrated circuit 30 is further electrically coupled to the substrate 10 by using a bonding wire 50. The optical fiber 71 is optically coupled to an optical port on a sidewall of the photonic integrated circuit 30. Because each bonding wire 50 has a specific loop height and a great length, large parasitic effect such as a parasitic inductance, a parasitic capacitor, and the like is generated. This causes large power consumption.

At present, the industry tends to use a flip-chip (flip-chip) technology to directly vertically interconnect the driver on the electronic chip with the modulator on the photonic chip, and then interconnect the electronic chip and the photonic chip with a substrate by using a through-silicon via (Through-Silicon-Via, TSV) on the photonic chip or the electronic chip. This photoelectric integration mode has a short interconnection path and a high I/O density, but requires that a TSV be produced on an active chip (a photonic chip or an electronic chip). The process of producing the TSV on the active chip is complicated and has a strict requirement for process precision. This causes high device manufacturing costs. In addition, because a stress caused by the TSV affects device performance of the photonic chip or the electronic chip, a stress safety region needs to be disposed, and the TSV is designed in the safety region. This reduces an effective utilization area of the chip in an invisible manner, and further increases costs.

Therefore, there is a need for an improved solution of integrating the photonic chip and the electronic chip.

### SUMMARY

Embodiments of the present disclosure provide a photoelectric transceiver assembly and a manufacturing method thereof, to resolve the foregoing problems and other potential problems existing in a conventional solution of integrating a photonic chip and an electronic chip.

According to a first aspect of the present disclosure, a photoelectric transceiver assembly is provided. The photoelectric transceiver assembly includes: an electronic integrated circuit, including a first surface, a second surface opposite to the first surface, and a first sidewall located between the first surface and the second surface; a molding compound, plastically packaging the electronic integrated circuit around the first sidewall, where the molding compound includes a third surface close to the first surface and a fourth surface close to the second surface, and the molding compound is provided with one or more through mold vias extending from the third surface to the fourth surface; a first redistribution layer, disposed on the first surface and the third surface and including a plurality of first bumps electrically coupled to the first surface and the one or more through mold vias; a second redistribution layer, disposed on the second surface and the fourth surface and including a plurality of second bumps electrically coupled to the second surface and the one or more through mold vias; and a photonic integrated circuit, electrically coupled to the plurality of second bumps by using a plurality of first solder balls.

In such an embodiment, the molding compound is used to pre-mold the electronic integrated circuit, and the molding compound is provided with the through mold via to implement electrical coupling between the photonic integrated circuit and a substrate. In this manner, the photonic integrated circuit and the electronic integrated circuit can be reliably integrated together.

In addition, because electrical coupling between the photonic integrated circuit and the electronic integrated circuit and between the substrate and both the photonic integrated circuit and the electronic integrated circuit is implemented by using the first redistribution layer, the second redistribution layer, and the through mold via, a conventional bonding wire with a specific loop height and a great length is not used, and parasitic effect caused by use of the bonding wire can be avoided. This reduces power consumption of the optical transceiver assembly.

In addition, because the electrical coupling between the photonic integrated circuit and the electronic integrated circuit and the electrical coupling between the substrate and both the photonic integrated circuit and the electronic integrated circuit are implemented by using the first redistribution layer, the second redistribution layer, and the through mold via, a complex manufacturing process of forming a TSV in the photonic integrated circuit or the electronic integrated circuit is avoided, and a stress safety region does not need to be disposed in the photonic integrated circuit or the electronic integrated circuit. This can significantly reduce costs of the optical transceiver assembly.

In addition, before an optical fiber is connected to the photonic integrated circuit, pre-molding needs to be performed only on the electronic integrated circuit, and no molding process needs to be performed on the photonic integrated circuit. Therefore, pollution on an optical port on the photonic integrated circuit can be avoided. This reduces a transmission loss between the optical fiber and the photonic integrated circuit after the optical fiber is connected to the photonic integrated circuit.

In some embodiments, the photoelectric transceiver assembly further includes a fiber array unit optically coupled to the photonic integrated circuit, where the molding compound further includes a notch disposed at an end that is of the molding compound and that is close to the fiber array unit, and the notch is configured to avoid the fiber array unit. In such an embodiment, the notch configured to avoid the fiber array unit is disposed in the molding compound, so that interference between the fiber array unit and the molding compound can be avoided, and the fiber array unit can be connected to the photonic integrated circuit.

In some embodiments, the first surface and the third surface are in a same plane. In such an embodiment, the first surface and the third surface are in the same plane, so that a manufacturing process for pre-molding the electronic integrated circuit by using the molding compound can be simplified, and the first redistribution layer can be formed on the two surfaces.

In some embodiments, the second surface and the fourth surface are in a same plane. In such an embodiment, the second surface and the fourth surface are in the same plane, so that a manufacturing process for pre-molding the electronic integrated circuit by using the molding compound can be simplified, and the second redistribution layer can be formed on the two surfaces.

In some embodiments, the photonic integrated circuit includes a fifth surface, a sixth surface opposite to the fifth surface, and a second sidewall located between the fifth surface and the sixth surface, and the fifth surface is electrically coupled to the plurality of second bumps in the second redistribution layer by using the plurality of first solder balls.

In some embodiments, the second redistribution layer further includes a first heat conducting layer in contact with the second surface of the electronic integrated circuit; and the photoelectric transceiver assembly further includes a first heat conducting block and a heat sink, the first heat conducting block is connected between the first heat conducting layer and the heat sink, and the heat sink is in contact with the sixth surface of the photonic integrated circuit. In such an embodiment, heat generated by the electronic integrated circuit can be effectively dissipated by using the first heat conducting layer, the first heat conducting block, and the heat sink, and heat generated by the photonic integrated circuit can also be effectively dissipated by using the heat sink. In this manner, device performance of the electronic integrated circuit and the photonic integrated circuit can be improved, and a service life of the device can be prolonged.

In some embodiments, the one or more through mold vias include one or more heat conducting vias, and one end of each of the one or more heat conducting vias is in contact with the first heat conducting layer; the first redistribution layer further includes a second heat conducting layer in contact with the other end of each of the one or more heat conducting vias; and the photoelectric transceiver assembly further includes a substrate and a second heat conducting block, the substrate is electrically coupled to the plurality of first bumps in the first redistribution layer by using a plurality of second solder balls, and the second heat conducting block is connected between the substrate and the second heat conducting layer. In such an embodiment, the heat generated by the electronic integrated circuit can be further conducted to the substrate and dissipated by using the heat conducting via, the second heat conducting layer, and the second heat conducting block. In this manner, device performance of the electronic integrated circuit can be further improved, and a service life of the device can be prolonged.

In some embodiments, the first redistribution layer further includes a third heat conducting layer in contact with the first surface of the electronic integrated circuit; and the photoelectric transceiver assembly further includes a substrate and a third heat conducting block, the substrate is electrically coupled to the plurality of first bumps in the first redistribution layer by using a plurality of second solder balls, and the third heat conducting block is connected between the substrate and the third heat conducting layer. In such an embodiment, heat generated by the electronic integrated circuit can be further conducted to the substrate and dissipated by using the third heat conducting layer and the third heat conducting block. In this manner, device performance of the electronic integrated circuit can be further improved, and a service life of the device can be prolonged.

According to a second aspect of the present disclosure, an optical module is provided. The optical module includes the photoelectric transceiver assembly according to the first aspect of the present disclosure.

According to a third aspect of the present disclosure, an optical switch is provided. The optical switch includes the photoelectric transceiver assembly according to the first aspect of the present disclosure.

According to a fourth aspect of the present disclosure, a manufacturing method of a photoelectric transceiver assembly is provided. The manufacturing method includes: spacing an electronic integrated circuit and one or more through mold vias on a carrier board, where the electronic integrated circuit includes a first surface, a second surface opposite to the first surface, and a first sidewall located between the first surface and the second surface, and the second surface faces the carrier board; forming a molding compound around the first sidewall to plastically package the electronic integrated circuit and the one or more through mold vias, where the molding compound includes a third surface close to the first surface and a fourth surface close to the second surface, and the one or more through mold vias extends from the third surface to the fourth surface; forming a first redistribution layer on the first surface and the third surface, where the first redistribution layer includes a plurality of first bumps electrically coupled to the first surface and the one or more through mold vias; removing the carrier board from the second surface and the fourth surface; forming a second redistribution layer on the second surface and the fourth surface, where the second redistribution layer includes a plurality of second bumps electrically coupled to the second surface and the one or more through mold vias; and electrically coupling a photonic integrated circuit to the plurality of second bumps in the second redistribution layer by using a plurality of first solder balls.

In such an embodiment, the molding compound is used to pre-mold the electronic integrated circuit, and the molding compound is provided with the through mold via to implement electrical coupling between the photonic integrated circuit and a substrate. In this manner, the photonic integrated circuit and the electronic integrated circuit can be reliably integrated together.

In addition, because electrical coupling between the photonic integrated circuit and the electronic integrated circuit and electrical coupling between the substrate and both the photonic integrated circuit and the electronic integrated circuit are implemented by using the first redistribution layer, the second redistribution layer, and the through mold via, a conventional bonding wire with a specific loop height and a great length is not used, and parasitic effect caused by use of the bonding wire can be avoided. This reduces power consumption of the optical transceiver assembly.

In addition, because the electrical coupling between the photonic integrated circuit and the electronic integrated circuit and the electrical coupling between the substrate and both the photonic integrated circuit and the electronic integrated circuit are implemented by using the first redistribution layer, the second redistribution layer, and the through mold via, a complex manufacturing process of forming a TSV in the photonic integrated circuit or the electronic integrated circuit is avoided, and a stress safety region does not need to be disposed in the photonic integrated circuit or the electronic integrated circuit. This can significantly reduce costs of the optical transceiver assembly.

In addition, before an optical fiber is connected to the photonic integrated circuit, pre-molding is performed only on the electronic integrated circuit, and no molding process is performed on the photonic integrated circuit. Therefore, pollution on an optical port on the photonic integrated circuit can be avoided. This can reduce a transmission loss between the optical fiber and the photonic integrated circuit after the optical fiber is connected to the photonic integrated circuit.

In some embodiments, the manufacturing method further includes optically coupling a fiber array unit to the photonic integrated circuit, where the forming a molding compound further includes: forming a notch at an end that is of the molding compound and that is close to the fiber array unit, where the notch is configured to avoid the fiber array unit. In such an embodiment, the notch configured to avoid the fiber array unit is formed in the molding compound, so that interference between the fiber array unit and the molding compound can be avoided, and the fiber array unit can be connected to the photonic integrated circuit.

In some embodiments, the first surface and the third surface are in a same plane. In such an embodiment, the first surface and the third surface are in the same plane, so that a manufacturing process for pre-molding the electronic integrated circuit by using the molding compound can be simplified, and the first redistribution layer can be formed on the two surfaces.

In some embodiments, the second surface and the fourth surface are in a same plane. In such an embodiment, the second surface and the fourth surface are in the same plane, so that a manufacturing process for pre-molding the electronic integrated circuit by using the molding compound can be simplified, and the second redistribution layer can be formed on the two surfaces.

In some embodiments, the photonic integrated circuit includes a fifth surface, a sixth surface opposite to the fifth surface, and a second sidewall located between the fifth surface and the sixth surface; and the electrically coupling a photonic integrated circuit to the plurality of second bumps in the second redistribution layer includes: electrically coupling the fifth surface to the plurality of second bumps in the second redistribution layer by using the plurality of first solder balls.

In some embodiments, the forming a second redistribution layer further includes: forming a first heat conducting layer in contact with the second surface of the electronic integrated circuit; and the manufacturing method further includes forming a first heat conducting block and a heat sink, where the first heat conducting block is connected between the first heat conducting layer and the heat sink, and the heat sink is in contact with the sixth surface of the photonic integrated circuit. In such an embodiment, heat generated by the electronic integrated circuit can be effectively dissipated by using the first heat conducting layer, the first heat conducting block, and the heat sink, and heat generated by the photonic integrated circuit can also be effectively dissipated by using the heat sink. In this manner, device performance of the electronic integrated circuit and the photonic integrated circuit can be improved, and a service life of the device can be prolonged.

In some embodiments, the one or more through mold vias include one or more heat conducting vias, one end of each of the one or more heat conducting vias is in contact with the first heat conducting layer, and the method further includes: forming, in the first redistribution layer, a second heat conducting layer in contact with the other end of each of the one or more heat conducting vias; electrically coupling a substrate to the plurality of first bumps in the first redistribution layer by using a plurality of second solder balls; and connecting the second heat conducting block between the substrate and the second heat conducting layer. In such an embodiment, the heat generated by the electronic integrated circuit can be further conducted to the substrate and dissipated by using the heat conducting via, the second heat conducting layer, and the second heat conducting block. In this manner, device performance of the electronic integrated circuit can be further improved, and a service life of the device can be prolonged.

In some embodiments, the manufacturing method further includes: forming, in the first redistribution layer, a third heat conducting layer in contact with the first surface of the electronic integrated circuit; electrically coupling a substrate to the plurality of first bumps in the first redistribution layer by using a plurality of second solder balls; and connecting the third heat conducting block between the substrate and the third heat conducting layer. In such an embodiment, heat generated by the electronic integrated circuit can be further conducted to the substrate and dissipated by using the third heat conducting layer and the third heat conducting block. In this manner, device performance of the electronic integrated circuit can be further improved, and a service life of the device can be prolonged.

The summary part is provided to describe a selection of concepts in a simplified form, and the concepts are further described in the following description of embodiments. The summary part is not intended to identify a key feature or an essential feature of the present disclosure or to limit a scope of the present disclosure.

### BRIEF DESCRIPTION OF DRAWINGS

The following detailed descriptions are read with reference to the accompanying drawings, so that the foregoing and other objectives, features, and advantages of embodiments of the present disclosure become easy to understand. In the accompanying drawings, several embodiments of the present disclosure are shown in a way of example instead of limitation.
FIG. 1 is a schematic diagram of a structure of a conventional optical transceiver module;
FIG. 2 is a top view of an optical transceiver assembly according to an embodiment of the present disclosure;
FIG. 3 is a schematic sectional view taken along a sectional line A-A shown in FIG. 2;
FIG. 4 is a schematic sectional view of an optical transceiver assembly according to another embodiment of the present disclosure;
FIG. 5 is a schematic sectional view of an optical transceiver assembly according to still another embodiment of the present disclosure; and
FIG. 6A to FIG. 6G show a schematic manufacturing process of an optical transceiver assembly according to an embodiment of the present disclosure.

In the accompanying drawings, same or corresponding reference numerals represent same or corresponding parts.

### DESCRIPTION OF EMBODIMENTS

Embodiments of the present disclosure are described in more detail in the following with reference to the accompanying drawings. Although preferred embodiments of the present disclosure are shown in the accompanying drawings, it should be understood that the present disclosure may be implemented in various forms and should not be limited to embodiments described herein. Rather, these embodiments are provided to make the present disclosure more thorough and complete and to fully convey the scope of the present disclosure to a person skilled in the art.

The term "include" and variants thereof used in this specification indicate open inclusion, that is, "include but is not limited to". Unless otherwise stated, the term "or" means "and/or". The term "based on" means "at least partially based on". The terms "an example embodiment" and "an embodiment" mean "at least one example embodiment". The term "another embodiment" means "at least one another embodiment". Terms such as "up", "down", "front", and "back" that indicate a placement or location relationship are based on an orientation or a location relationship shown in the accompanying drawings, and are merely used to describe a principle of the present disclosure, but do not indicate or imply that a specified element needs to have a specific orientation or be constructed or operated in a specific orientation. Therefore, the terms cannot be understood as a limitation on the present disclosure.

As described above, when integration of a photonic chip and an electronic chip is implemented by using a conventional wire seating interconnection solution, because each bonding wire has a specific loop height and a great length, large parasitic effect such as a parasitic inductance, a parasitic capacitor, and the like is generated. This causes large power consumption. However, when integration of a photonic chip and an electronic chip is implemented by using a flip-chip and TSV process, the process of manufacturing the TSV is complicated and has a strict requirement for process precision. This causes quite high device manufacturing costs. In addition, because a stress safety region needs to be disposed in the photonic chip or the electronic chip, an effective utilization area of the chip is reduced, and costs are further increased. Embodiments of the present disclosure provide a photoelectric transceiver assembly and a manufacturing method thereof, to resolve the foregoing problems and other potential problems existing in a conventional solution of integrating a photonic chip and an electronic chip. Principles of the present disclosure are described in detail below with reference to the accompanying drawings and example embodiments.

In this specification, the terms "photonic integrated circuit" and "photonic chip" may be used interchangeably, and the terms "electronic integrated circuit" and "electronic chip" may be used interchangeably. For example, a driver (which may also be referred to as a drive circuit or a drive chip) and another functional unit may be disposed in the electronic integrated circuit. For example, a modulator (which may also be referred to as a modulation circuit) and another function may be disposed in the photonic integrated circuit. Embodiments of the present disclosure are intended to improve a layout manner and a connection manner of the electronic integrated circuit and the photonic integrated circuit, but are not intended to improve circuit structures of the electronic integrated circuit and the photonic integrated circuit. Therefore, the circuit structures of the electronic integrated circuit and the photonic integrated circuit are not described in detail in this specification. The electronic integrated circuit and the photonic integrated circuit may have various known structures or other structures available in the future. The scope of the present disclosure is not strictly limited in this aspect.

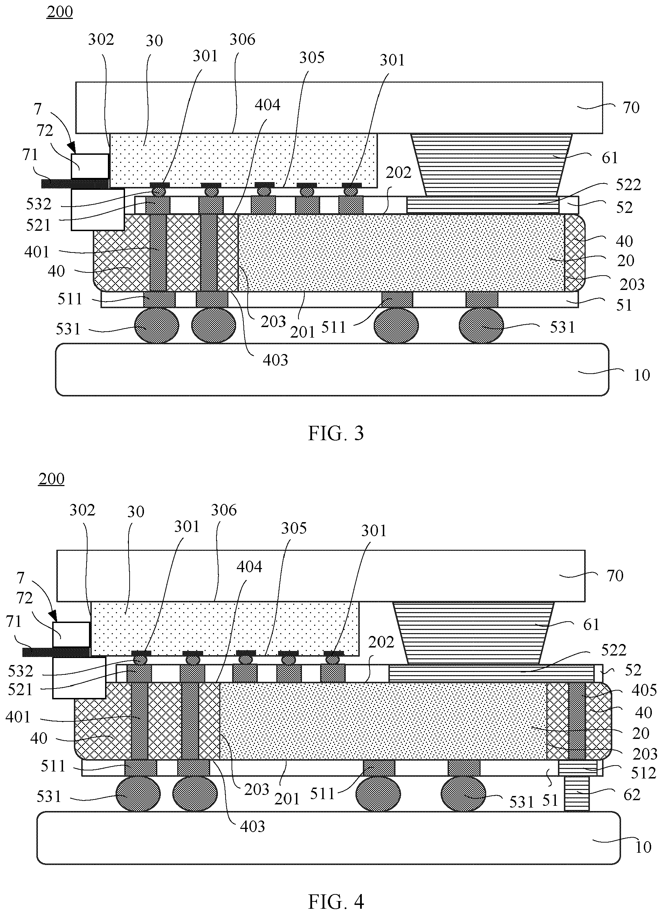

The following describes a structure of an optical transceiver assembly according to an embodiment of the present disclosure with reference to FIG. 2 and FIG. 3. FIG. 2 is a top view of an optical transceiver assembly according to an embodiment of the present disclosure, and FIG. 3 is a schematic sectional view taken along a sectional line A-A shown in FIG. 2. To show a relative layout of parts of the optical transceiver assembly in a horizontal direction more clearly in the top view, some parts are omitted in FIG. 2. For example, a heat sink 70 and a first heat conducting block 61 are shown in FIG. 3, but are not shown in FIG. 2.

As shown in FIG. 2 and FIG. 3, in general, the photoelectric transceiver assembly 200 described herein includes a substrate 10, an electronic integrated circuit 20, a molding compound 40, a photonic integrated circuit 30, and a fiber array unit 7.

In some embodiments, the substrate 10 may include a printed circuit board (PCB). In some other embodiments, the substrate 10 may include a ceramic substrate. In another embodiment, the substrate 10 may alternatively be of another type. This is not strictly limited in this aspect in this embodiment of the present disclosure.

As shown in FIG. 3, the electronic integrated circuit 20 includes a first surface 201, a second surface 202 opposite to the first surface 201, and a first sidewall 203 located between the first surface 201 and the second surface 202. The first surface 201 of the electronic integrated circuit 20 faces the substrate 10, and the second surface 202 of the electronic integrated circuit 20 backs onto the substrate 10.

As shown in FIG. 2 and FIG. 3, the molding compound 40 plastically packages the electronic integrated circuit 20 around the first sidewall 203 of the electronic integrated circuit 20. The molding compound 40 includes a third surface 403 close to the first surface 201 and a fourth surface 404 close to the second surface 202. The molding compound 40 may be made of epoxy resin or another molding compound. This is not strictly limited in this aspect in this embodiment of the present disclosure. The molding compound 40 is provided with a through mold via 401 extending from the third surface 403 to the fourth surface 404. The through mold via 401 may be made of copper, another metal, or a conductive material of another type, to form a conductive path extending from the third surface 403 to the fourth surface 404 in the molding compound 40. FIG. 3 shows two through mold vias 401 to illustrate a principle of an embodiment of the present disclosure. However, it should be understood that there may be one or more through mold vias 401. This is not strictly limited in this aspect in this embodiment of the present disclosure.

As shown in FIG. 3, a first redistribution layer 51 is disposed on the first surface 201 of the electronic integrated circuit 20 and the third surface 403 of the molding compound 40. The first redistribution layer 51 includes a plurality of first bumps 511 electrically coupled to the first surface 201 of the electronic integrated circuit 20 and the through mold via 401 in the molding compound 40. A quantity of first bumps 511 may be two, three, four, or more. This is not strictly limited in this aspect in this embodiment of the present disclosure. The substrate 10 may be electrically coupled to the plurality of first bumps 511 in the first redistribution layer 51 by using a plurality of second solder balls 531.

As shown in FIG. 3, a second redistribution layer 52 is disposed on the second surface 202 of the electronic integrated circuit 20 and the fourth surface 404 of the molding compound 40. The second redistribution layer 52 includes a plurality of second bumps 521 electrically coupled to the second surface 202 of the electronic integrated circuit 20 and the through mold via 401 in the molding compound 40. A quantity of second bumps 521 may be two, three, four, five, or more. This is not strictly limited in this aspect in this embodiment of the present disclosure. The photonic integrated circuit 30 is electrically coupled to the plurality of second bumps 521 in the second redistribution layer 52 by using a plurality of first solder balls 532.

As shown in FIG. 2 and FIG. 3, the light array unit 7 is optically coupled to the photonic integrated circuit 30, to transmit an optical signal to the photonic integrated circuit 30, or receive an optical signal from the photonic integrated circuit 30, to transmit the optical signal to another external circuit. In some embodiments, the fiber array unit 7 includes an optical fiber 71 and a cover 72. The optical fiber 71 is optically coupled to an optical port (not shown) on the photonic integrated circuit 30. The cover 72 is configured to fasten and install the optical fiber 71. In another embodiment, the fiber array unit 7 may have another structure. This is not strictly limited in this aspect in this embodiment of the present disclosure.

According to embodiments of the present disclosure, the molding compound 40 is used to pre-mold the electronic integrated circuit 20, and the molding compound 40 is provided with the through mold via 401 to implement electrical coupling between the photonic integrated circuit 30 and the substrate 10. In this manner, the photonic integrated circuit 30 and the electronic integrated circuit 20 can be reliably integrated together.

In addition, because electrical coupling between the photonic integrated circuit 30 and the electronic integrated circuit 20 and between the substrate 10 and both the photonic integrated circuit 30 and the electronic integrated circuit 20 is implemented by using the first redistribution layer 51, the second redistribution layer 52, and the through mold via 401, a conventional bonding wire with a specific loop height and a great length is not used, and parasitic effect caused by use of the bonding wire can be avoided. This reduces power consumption of the optical transceiver assembly 200.

In addition, because the electrical coupling between the photonic integrated circuit 30 and the electronic integrated circuit 20 and between the substrate 10 and both the photonic integrated circuit 30 and the electronic integrated circuit 20 is implemented by using the first redistribution layer 51, the second redistribution layer 52, and the through mold via 401, a complex manufacturing process of forming a TSV in the photonic integrated circuit 30 or the electronic integrated circuit 20 is avoided, and a stress safety region does not need to be disposed in the photonic integrated circuit 30 or the electronic integrated circuit 20. This can significantly reduce costs of the optical transceiver assembly 200.

In addition, before the optical fiber 71 is connected to the photonic integrated circuit 30, pre-molding needs to be performed only on the electronic integrated circuit 20, and no molding process needs to be performed on the photonic integrated circuit 30. Therefore, pollution on the optical port on the photonic integrated circuit 30 can be avoided. This reduces a transmission loss between the optical fiber 71 and the photonic integrated circuit 30 after the optical fiber 71 is connected to the photonic integrated circuit 30.

In some embodiments, as shown in FIG. 2 and FIG. 3, the molding compound 40 further includes a notch 402 disposed at one end that is of the molding compound 40 and that is close to the fiber array unit 7. As shown in FIG. 2, the notch 402 can completely penetrate the molding compound 40 in a direction perpendicular to the substrate 10. The notch 402 configured to avoid the fiber array unit 7 is disposed in the molding compound 40, so that interference between the fiber array unit 7 and the molding compound 4 can be avoided, and the fiber array unit 7 can be connected to the photonic integrated circuit 30. In another embodiment, the notch 402 may partially pass through the molding compound 40 in a direction perpendicular to the substrate 10. In addition, as shown in FIG. 2, a projection of the notch 402 in the top view may be a rectangle. In another embodiment, the projection of the notch 402 in the top view may be in another shape. This is not strictly limited in this aspect in this embodiment of the present disclosure.

In some embodiments, as shown in FIG. 3, the first surface 201 of the electronic integrated circuit 20 and the third surface 403 of the molding compound 40 are basically in a same plane (that is, coplanar). Such an arrangement is used, so that a manufacturing process for pre-molding the electronic integrated circuit 20 by using the molding compound 40 can be simplified, and the first redistribution layer 51 can be formed on the first surface 201 and the third surface 403. In another embodiment, the first surface 201 of the electronic integrated circuit 20 and the third surface 403 of the molding compound 40 may not be coplanar. This increases process difficulty to some extent, but does not affect implementation of a circuit function.

In some embodiments, as shown in FIG. 3, the second surface 202 of the electronic integrated circuit 20 and the fourth surface 404 of the molding compound 40 are basically in a same plane (that is, coplanar). Such an arrangement is used, so that the manufacturing process for pre-molding the electronic integrated circuit 20 by using the molding compound 40 can be simplified, and the second redistribution layer 52 can be formed on the second surface 202 and the fourth surface 404. In another embodiment, the second surface 202 of the electronic integrated circuit 20 and the fourth surface 404 of the molding compound 40 may not be coplanar. This increases process difficulty to some extent, but does not affect implementation of a circuit function.

As shown in FIG. 3, the photonic integrated circuit 30 includes a fifth surface 305, a sixth surface 306 opposite to the fifth surface 305, and a second sidewall 302 located between the fifth surface 305 and the sixth surface 306. The fifth surface 305 faces the molding compound 40 and the electronic integrated circuit 20, and the sixth surface backs onto the molding compound 40 and the electronic integrated circuit 20. The fifth surface 305 is electrically coupled to the second bump 521 in the second redistribution layer 52 by using the first solder ball 532.

Because the photonic integrated circuit 30 and the electronic integrated circuit 20 generate heat during operation, if the generated heat is not dissipated in time, performance and a service life of the photonic integrated circuit 30 and the electronic integrated circuit 20 are affected. Therefore, in some embodiments, as shown in FIG. 3, the second redistribution layer 52 further includes a first heat conducting layer 522 in contact with the second surface 202 of the electronic integrated circuit 20, and the photoelectric transceiver assembly 200 further includes a first heat conducting block 61 and a heat sink 70. The first heat conducting block 61 is connected between the first heat conducting layer 522 and the heat sink 70, to form a heat dissipation path from the second surface 202 of the electronic integrated circuit 20 to the first heat conducting layer 522 and the first heat conducting block 61, and to the heat sink 70, so that the heat generated by the electronic integrated circuit 20 can be dissipated from the second surface 202 in time. In addition, the heat sink 70 is further in contact with the sixth surface 306 of the photonic integrated circuit 30, so that the heat generated by the photonic integrated circuit 30 can be dissipated from the sixth surface 306 in time. The first heat conducting layer 522 and the first heat conducting block 61 may be made of copper, another metal, or a heat dissipation material of another type. This is not strictly limited in this aspect in this embodiment of the present disclosure. The first heat conducting layer 522 and the first heat conducting block 61 may include a same material or different materials. This is not strictly limited in this aspect in this embodiment of the present disclosure.

FIG. 4 is a schematic sectional view of an optical transceiver assembly according to another embodiment of the present disclosure. A structure of the optical transceiver assembly 200 in embodiments shown in FIG. 4 is similar to a structure of the optical transceiver assembly 200 in embodiments shown in FIG. 3, and a difference lies in that the optical transceiver assembly 200 in embodiments shown in FIG. 4 further includes an additional heat dissipation path. Only differences between the two optical transceiver assemblies 200 are described in detail in this specification, and a same part of the two is not described herein again.

As shown in FIG. 4, the through mold via 401 includes a heat conducting via 405, the heat conducting via 405 extends from the third surface 403 to the fourth surface 404, and one end (top end) of the heat conducting via 405 is in contact with the first heat conducting layer 522. In addition, the first redistribution layer 51 further includes a second heat conducting layer 512 in contact with the other end (bottom end) of the heat conducting via 405. The photoelectric transceiver assembly 200 further includes a second heat conducting block 62, and the second heat conducting block 62 is connected between the substrate 10 and the second heat conducting layer 512. Such an arrangement is used, so that an additional heat dissipation path from the second surface 202 of the electronic integrated circuit 20 to the first heat conducting layer 522, the heat conducting via 405, the second heat conducting layer 512, and the second heat conducting block 62, and to the substrate 10 is formed. In this manner, the heat generated by the electronic integrated circuit 20 during operation can be conducted to the substrate 10 through the additional heat dissipation path and dissipated, so that heat dissipation performance of the electronic integrated circuit 20 can be further improved.

FIG. 4 shows only one heat conducting via 405 to illustrate a principle of an embodiment of the present disclosure. However, it should be understood that there may be one or more heat conducting vias 405. This is not strictly limited in this aspect in this embodiment of the present disclosure.

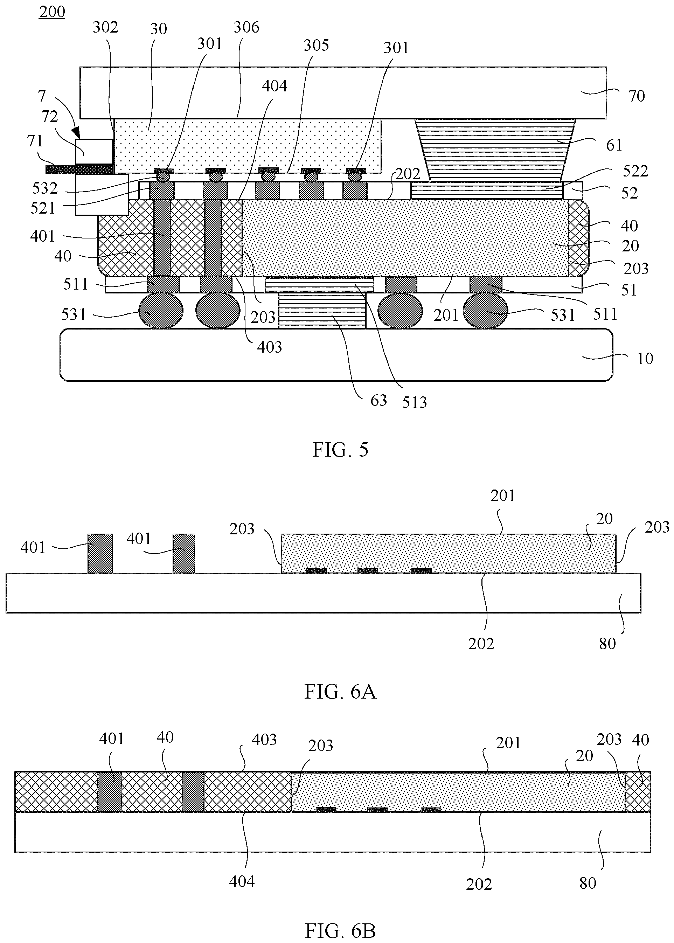

FIG. 5 is a schematic sectional view of an optical transceiver assembly according to still another embodiment of the present disclosure. A structure of the optical transceiver assembly 200 in embodiments shown in FIG. 5 is similar to the structure of the optical transceiver assembly 200 in embodiments shown in FIG. 3, and a difference lies in that the optical transceiver assembly 200 in embodiments shown in FIG. 5 further includes another additional heat dissipation path. Only differences between the two optical transceiver assemblies 200 are described in detail in this specification, and a same part of the two is not described herein again.

As shown in FIG. 5, the first redistribution layer 51 further includes a third heat conducting layer 513 in contact with the first surface 201 of the electronic integrated circuit 20. In addition, the photoelectric transceiver assembly 200 further includes a third heat conducting block 63, and the third heat conducting block 63 is connected between the substrate 10 and the third heat conducting layer 513. Such an arrangement is used, so that an additional heat dissipation path from the first surface 201 of the electronic integrated circuit 20 to the third heat conducting layer 513 and the third heat conducting block 63, and to the substrate 10 is formed. In this manner, the heat generated by the electronic integrated circuit 20 during operation can be conducted to the substrate 10 through the additional heat dissipation path and dissipated, so that heat dissipation performance of the electronic integrated circuit 20 can be further improved.

In some embodiments, the optical transceiver assembly 200 described above may be used in an optical module, to perform optical communication. In some other embodiments, the optical transceiver assembly 200 described above may be used in an optical switch, to perform optical communication. It should be understood that the optical transceiver assembly 200 may be used in various electronic devices. This is not strictly limited in this aspect in this embodiment of the present disclosure.

For example, the following describes a manufacturing method of an optical transceiver assembly according to an embodiment of the present disclosure. FIG. 6A to FIG. 6G show a schematic manufacturing process of an optical transceiver assembly according to an embodiment of the present disclosure.

As shown in FIG. 6A, space an electronic integrated circuit 20 and a through mold via 401 on a carrier board 80. The electronic integrated circuit 20 includes a first surface 201, a second surface 202 opposite to the first surface 201, and a first sidewall 203 located between the first surface 201 and the second surface 202, and the second surface 202 faces the carrier board 80. FIG. 6A shows two through mold vias 401 to illustrate a principle of an embodiment of the present disclosure. However, it should be understood that there may be one or more through mold vias 401. This is not strictly limited in this aspect in this embodiment of the present disclosure.

As shown in FIG. 6B, form a molding compound 40 around the first sidewall 203 of the electronic integrated circuit 20 to plastically package the electronic integrated circuit 20 and the through mold via 401. A first surface 201 of the electronic integrated circuit 20 may be exposed by using a polishing process, or a process parameter of a molding process is controlled, so that a first surface 201 of the electronic integrated circuit 20 is not covered by the molding compound 40. The molding compound 40 includes a third surface 403 close to the first surface 201 and a fourth surface 404 close to the second surface 202, and one or more through mold vias 401 extend from the third surface 403 to the fourth surface 404.

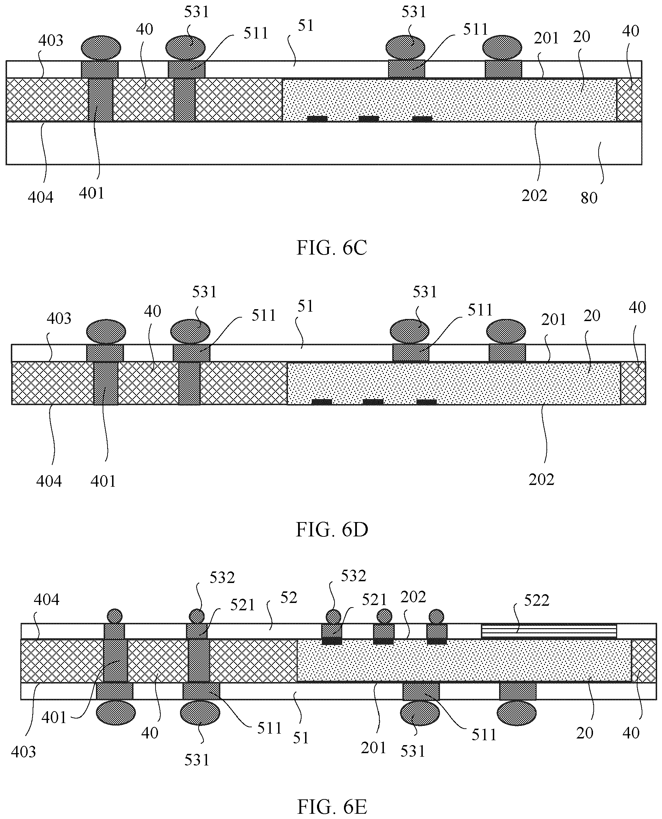

As shown in FIG. 6C, form a first redistribution layer 51 on the first surface 201 of the electronic integrated circuit 20 and the third surface 403 of the molding compound 40. The first redistribution layer 51 includes a plurality of first bumps 511 electrically coupled to the first surface 201 and the one or more through mold vias 401. A quantity of first bumps 511 may be two, three, four, or more. This is not strictly limited in this aspect in this embodiment of the present disclosure. As shown in FIG. 6C, further form a plurality of second solder balls 531 on the first bumps 511 to be electrically coupled to a substrate 10 in a subsequent step. It should be understood that the second solder ball 531 may alternatively be formed when the substrate 10 is coupled in a subsequent step. This is not strictly limited in this aspect in this embodiment of the present disclosure.

As shown in FIG. 6D, remove the carrier board 80 from the second surface 202 and the fourth surface 404, to expose the second surface 202 of the electronic integrated circuit 20 and the fourth surface 404 of the molding compound 40.

As shown in FIG. 6E, form a second redistribution layer 52 on the second surface 202 of the electronic integrated circuit 20 and the fourth surface 404 of the molding compound 40. The second redistribution layer 52 includes a plurality of second bumps 521 electrically coupled to the second surface 202 and the through mold via 401. A quantity of second bumps 521 may be two, three, four, five, or more. This is not strictly limited in this aspect in this embodiment of the present disclosure. As shown in FIG. 6E, further form a plurality of first solder balls 532 on the second bumps 521 to be electrically coupled to a photonic integrated circuit 30 in a subsequent step. In some embodiments, as shown in FIG. 6E, the second redistribution layer 52 further includes a first heat conducting layer 522 in contact with the second surface 202 of the electronic integrated circuit 20.

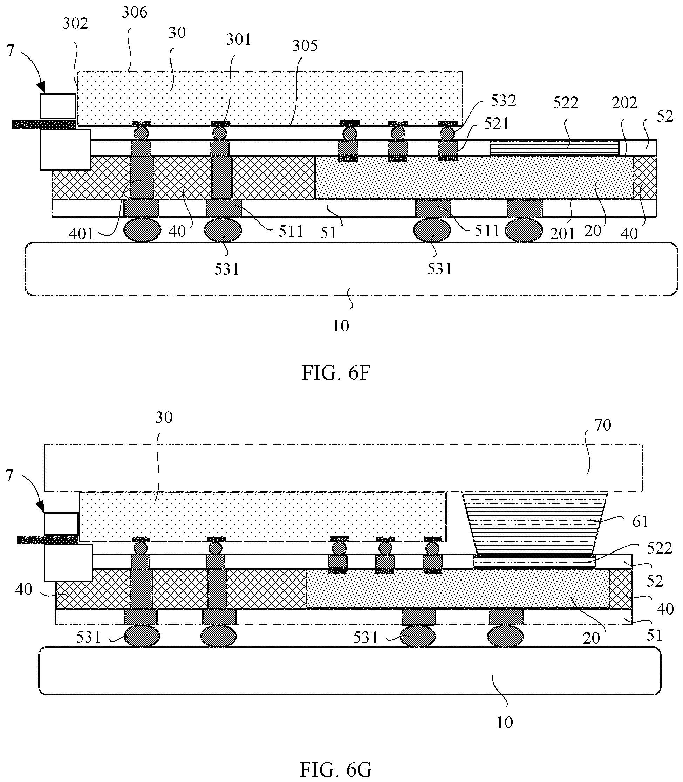

As shown in FIG. 6F, electrically couple the photonic integrated circuit 30 to the plurality of second bumps 521 in the second redistribution layer 52 by using the first solder balls 532. In some embodiments, a light array unit 7 may be further optically coupled to the photonic integrated circuit 30, to transmit an optical signal to the photonic integrated circuit 30, or receive an optical signal from the photonic integrated circuit 30, to transmit the optical signal to another external circuit. In some embodiments, the substrate 10 may be further electrically coupled to the plurality of first bumps 511 in the first redistribution layer 51 by using the plurality of second solder balls 531.

In some embodiments, as shown in FIG. 6G, further form a first heat conducting block 61 and a heat sink 70. The first heat conducting block 61 is connected between the first heat conducting layer 522 and the heat sink 70, to form a heat dissipation path from the second surface 202 of the electronic integrated circuit 20 to the first heat conducting layer 522 and the first heat conducting block 61, and to the heat sink 70, so that heat generated by the electronic integrated circuit 20 can be dissipated from the second surface 202 in time. In addition, the heat sink 70 is further in contact with the photonic integrated circuit 30, so that heat generated by the photonic integrated circuit 30 can be dissipated in time.

In some embodiments, with reference to FIG. 2 and FIG. 6B, the forming a molding compound 40 further includes: forming a notch 402 at an end that is of the molding compound 40 and that is close to the fiber array unit 7, where the notch 402 is configured to avoid the fiber array unit 7.

In some embodiments, as shown in FIG. 6B, the first surface 201 of the electronic integrated circuit 20 and the third surface 403 of the molding compound 40 are basically in a same plane (that is, coplanar). Such an arrangement is used, so that a manufacturing process for pre-molding the electronic integrated circuit 20 by using the molding compound 40 can be simplified, and the first redistribution layer 51 can be formed on the first surface 201 and the third surface 403. In another embodiment, the first surface 201 of the electronic integrated circuit 20 and the third surface 403 of the molding compound 40 may not be coplanar. This increases process difficulty to some extent, but does not affect implementation of a circuit function.

In some embodiments, as shown in FIG. 6D, the second surface 202 of the electronic integrated circuit 20 and the fourth surface 404 of the molding compound 40 are basically in a same plane (that is, coplanar). Such an arrangement is used, so that the manufacturing process for pre-molding the electronic integrated circuit 20 by using the molding compound 40 can be simplified, and the second redistribution layer 52 can be formed on the second surface 202 and the fourth surface 404. In another embodiment, the second surface 202 of the electronic integrated circuit 20 and the fourth surface 404 of the molding compound 40 may not be coplanar. This increases process difficulty to some extent, but does not affect implementation of a circuit function.

In some embodiments, as shown in FIG. 6F, the photonic integrated circuit 30 includes a fifth surface 305, a sixth surface 306 opposite to the fifth surface 305, and a second sidewall 302 located between the fifth surface 305 and the sixth surface 306. The fifth surface 305 faces the molding compound 40 and the electronic integrated circuit 20, and the sixth surface backs onto the molding compound 40 and the electronic integrated circuit 20. The fifth surface 305 is electrically coupled to the second bump 521 in the second redistribution layer 52 by using the first solder ball 532.

In some embodiments, with reference to FIG. 4, the through mold via 401 includes a heat conducting via 405, the heat conducting via 405 extends from the third surface 403 to the fourth surface 404, and one end (top end) of the heat conducting via 405 is in contact with the first heat conducting layer 522. In addition, the first redistribution layer 51 further includes a second heat conducting layer 512 in contact with the other end (bottom end) of the heat conducting via 405. The photoelectric transceiver assembly 200 further includes a second heat conducting block 62, and the second heat conducting block 62 is connected between the substrate 10 and the second heat conducting layer 512. Such an arrangement is used, so that an additional heat dissipation path from the second surface 202 of the electronic integrated circuit 20 to the first heat conducting layer 522, the heat conducting via 405, the second heat conducting layer 512, and the second heat conducting block 62, and to the substrate 10 is formed. In this manner, the heat generated by the electronic integrated circuit 20 during operation can be conducted to the substrate 10 through the additional heat dissipation path and dissipated, so that heat dissipation performance of the electronic integrated circuit 20 can be further improved.

In some embodiments, with reference to FIG. 5, the first redistribution layer 51 further includes a third heat conducting layer 513 in contact with the first surface 201 of the electronic integrated circuit 20. In addition, the photoelectric transceiver assembly 200 further includes a third heat conducting block 63, and the third heat conducting block 63 is connected between the substrate 10 and the third heat conducting layer 513. Such an arrangement is used, so that an additional heat dissipation path from the first surface 201 of the electronic integrated circuit 20 to the third heat conducting layer 513 and the third heat conducting block 63, and to the substrate 10 is formed. In this manner, the heat generated by the electronic integrated circuit 20 during operation can be conducted to the substrate 10 through the additional heat dissipation path and dissipated, so that heat dissipation performance of the electronic integrated circuit 20 can be further improved.

Embodiments of the present disclosure are described above. The foregoing descriptions are examples, are not exhaustive, and are not limited to the disclosed embodiments. Many modifications and variations are apparent to a person of ordinary skill in the art without departing from the scope and spirit of the described embodiments. Selection of terms used in this specification is intended to best explain the principles of embodiments, actual application, or improvements to technologies in the market, or to enable another person of ordinary skill in the art to understand embodiments disclosed in this specification.

## Claims

1. A photoelectric transceiver assembly (200), comprising:
an electronic integrated circuit (20), comprising a first surface (201), a second surface (202) opposite to the first surface (201), and a first sidewall (203) located between the first surface (201) and the second surface (202);
a molding compound (40), plastically packaging the electronic integrated circuit (20) around the first sidewall (203), wherein the molding compound (40) comprises a third surface (403) close to the first surface (201) and a fourth surface (404) close to the second surface (202), and the molding compound (40) is provided with one or more through mold vias (401) extending from the third surface (403) to the fourth surface (404);
a first redistribution layer (51), disposed on the first surface (201) and the third surface (403) and comprising a plurality of first bumps (511) electrically coupled to the first surface (201) and the one or more through mold vias (401);
a second redistribution layer (52), disposed on the second surface (202) and the fourth surface (404) and comprising a plurality of second bumps (521) electrically coupled to the second surface (202) and the one or more through mold vias (401); and
a photonic integrated circuit (30), electrically coupled to the plurality of second bumps (521) by using a plurality of first solder balls (532).

2. The photoelectric transceiver assembly (200) according to claim 1, further comprising a fiber array unit (7) optically coupled to the photonic integrated circuit (30), wherein the molding compound (40) further comprises a notch (402) disposed at an end that is of the molding compound (40) and that is close to the fiber array unit (7), and the notch (402) is configured to avoid the fiber array unit (7).

3. The photoelectric transceiver assembly (200) according to claim 1, wherein the first surface (201) and the third surface (403) are in a same plane.

4. The photoelectric transceiver assembly (200) according to claim 1, wherein the second surface (202) and the fourth surface (404) are in a same plane.

5. The photoelectric transceiver assembly (200) according to claim 1, wherein the photonic integrated circuit (30) comprises a fifth surface (305), a sixth surface (306) opposite to the fifth surface (305), and a second sidewall (302) located between the fifth surface (305) and the sixth surface (306), and the fifth surface (305) is electrically coupled to the plurality of second bumps (521) in the second redistribution layer (52) by using the plurality of first solder balls (532).

6. The photoelectric transceiver assembly (200) according to claim 5, wherein the second redistribution layer (52) further comprises a first heat conducting layer (522) in contact with the second surface (202) of the electronic integrated circuit (20), and
the photoelectric transceiver assembly (200) further comprises a first heat conducting block (61) and a heat sink (70), the first heat conducting block (61) is connected between the first heat conducting layer (522) and the heat sink (70), and the heat sink (70) is in contact with the sixth surface (306) of the photonic integrated circuit (30).

7. The photoelectric transceiver assembly (200) according to claim 6, wherein the one or more through mold vias (401) comprise one or more heat conducting vias (405), and one end of each of the one or more heat conducting vias (405) is in contact with the first heat conducting layer (522);
the first redistribution layer (51) further comprises a second heat conducting layer (512) in contact with the other end of each of the one or more heat conducting vias (405); and
the photoelectric transceiver assembly (200) further comprises a substrate (10) and a second heat conducting block (62), the substrate (10) is electrically coupled to the plurality of first bumps (511) in the first redistribution layer (51) by using a plurality of second solder balls (531), and the second heat conducting block (62) is connected between the substrate (10) and the second heat conducting layer (512).

8. The photoelectric transceiver assembly (200) according to claim 1, wherein the first redistribution layer (51) further comprises a third heat conducting layer (513) in contact with the first surface (201) of the electronic integrated circuit (20), and
the photoelectric transceiver assembly (200) further comprises a substrate (10) and a third heat conducting block (63), the substrate (10) is electrically coupled to the plurality of first bumps (511) in the first redistribution layer (51) by using a plurality of second solder balls (531), and the third heat conducting block (63) is connected between the substrate (10) and the third heat conducting layer (513).

9. An optical module, comprising the photoelectric transceiver assembly (200) according to any one of claims 1 to 8.

10. An optical switch, comprising the photoelectric transceiver assembly (200) according to any one of claims 1 to 8.

11. A manufacturing method of a photoelectric transceiver assembly (200), comprising:
spacing an electronic integrated circuit (20) and one or more through mold vias (401) on a carrier board (80), wherein the electronic integrated circuit (20) comprises a first surface (201), a second surface (202) opposite to the first surface (201), and a first sidewall (203) located between the first surface (201) and the second surface (202), and the second surface (202) faces the carrier board (80);
forming a molding compound (40) around the first sidewall (203) to plastically package the electronic integrated circuit (20) and the one or more through mold vias (401), wherein the molding compound (40) comprises a third surface (403) close to the first surface (201) and a fourth surface (404) close to the second surface (202), and the one or more through mold vias (401) extends from the third surface (403) to the fourth surface (404);
forming a first redistribution layer (51) on the first surface (201) and the third surface (403), wherein the first redistribution layer (51) comprises a plurality of first bumps (511) electrically coupled to the first surface (201) and the one or more through mold vias (401);
removing the carrier board (80) from the second surface (202) and the fourth surface (404);
forming a second redistribution layer (52) on the second surface (202) and the fourth surface (404), wherein the second redistribution layer (52) comprises a plurality of second bumps (521) electrically coupled to the second surface (202) and the one or more through mold vias (401); and
electrically coupling a photonic integrated circuit (30) to the plurality of second bumps (521) in the second redistribution layer (52) by using a plurality of first solder balls (532).

12. The manufacturing method according to claim 11, further comprising optically coupling a fiber array unit (7) to the photonic integrated circuit (30), wherein
the forming a molding compound (40) further comprises: forming a notch (402) at an end that is of the molding compound (40) and that is close to the fiber array unit (7), wherein the notch (402) is configured to avoid the fiber array unit (7).

13. The manufacturing method according to claim 11, wherein the first surface (201) and the third surface (403) are in a same plane.

14. The manufacturing method according to claim 11, wherein the second surface (202) and the fourth surface (404) are in a same plane.

15. The manufacturing method according to claim 11, wherein the photonic integrated circuit (30) comprises a fifth surface (305), a sixth surface (306) opposite to the fifth surface (305), and a second sidewall (302) located between the fifth surface (305) and the sixth surface (306), and
the electrically coupling a photonic integrated circuit (30) to the plurality of second bumps (521) in the second redistribution layer (52) comprises: electrically coupling the fifth surface (305) to the plurality of second bumps (521) in the second redistribution layer (52) by using the plurality of first solder balls (532).

16. The manufacturing method according to claim 15, wherein the forming a second redistribution layer (52) further comprises: forming a first heat conducting layer (522) in contact with the second surface (202) of the electronic integrated circuit (20), and
the manufacturing method further comprises forming a first heat conducting block (61) and a heat sink (70), wherein the first heat conducting block (61) is connected between the first heat conducting layer (522) and the heat sink (70), and the heat sink (70) is in contact with the sixth surface (306) of the photonic integrated circuit (30).

17. The manufacturing method according to claim 16, wherein the one or more through mold vias (401) comprise one or more heat conducting vias (405), one end of each of the one or more heat conducting vias (405) is in contact with the first heat conducting layer (522), and the method further comprises:
forming, in the first redistribution layer (51), a second heat conducting layer (512) in contact with the other end of each of the one or more heat conducting vias (405);
electrically coupling a substrate (10) to the plurality of first bumps (511) in the first redistribution layer (51) by using a plurality of second solder balls (531); and
connecting the second heat conducting block (62) between the substrate (10) and the second heat conducting layer (512).

18. The manufacturing method according to claim 11, further comprising:
forming, in the first redistribution layer (51), a third heat conducting layer (513) in contact with the first surface (201) of the electronic integrated circuit (20);
electrically coupling a substrate (10) to the plurality of first bumps (511) in the first redistribution layer (51) by using a plurality of second solder balls (531); and
connecting the third heat conducting block (63) between the substrate (10) and the third heat conducting layer (513).
